## Europäisches Patentamt

## European Patent Office

## Office européen des brevets

(19)

(11) Veröffentlichungsnummer: **0 083 900**

**A2**

(12) **EUROPÄISCHE PATENTANMELDUNG**

(21) Anmeldenummer: **82710061.1**

(22) Anmeldetag: **31.12.82**

(51) Int. Cl.³: **G 11 C 19/30**
**G 02 F 1/13**

(30) Priorität: **12.01.82 SE 8200123**

(43) Veröffentlichungstag der Anmeldung:
**20.07.83 Patentblatt 83/29**

(84) Benannte Vertragsstaaten:
**CH DE FR GB LI**

(71) Anmelder: **ASEA AB**

**S-721 83 Västeras(SE)**

(72) Erfinder: **Brogardh, Torgny**
**Platverksgatan 140**
**S-724 74 Västeras(SE)**

(74) Vertreter: **Boecker, Joachim, Dr.-Ing.**
**Rathenauplatz 2-8**
**D-6000 Frankfurt a.M. 1(DE)**

(54) **Anordnung zur Umwandlung von Informationen aus der elektrischen Form in die optische Form und/oder umgekehrt.**

(57) Anordnung zur Umwandlung von Informationen aus der elektrischen Form in die optische Form und/oder umgekehrt, wobei die Information als eine in einer, zwei oder drei Dimensionen und/oder zeitlich variierende Lichtintensität und/oder Lichtpolarisation und/oder Spektralzusammensetzung vorliegt und wobei die Umwandlung der Information durch elektrooptische Modulatoren, die z.B. aus Flüssigkristallen bestehen, und Fotodetektoren, wie z.B. Fotowiderständen erfolgt. Gemäß der Erfindung bestehen die elektrooptischen Modulatoren (1) aus einem Material mit innewohnender Hysterese hinsichtlich der Abhängigkeit der Lichttransmission von der Modulatorspannung. Die Modulatoren (1a, 1b ...) befinden sich im Strahlengang zwischen mindestens einer Lichtquelle und Fotodetektoren (2a, 2b ..), von denen mindestens einer, von der Lichtquelle aus gesehen, hinter jedem Modulator (1) angeordnet ist. Jeder Modulator hat auf seiner einen Seite eine von den übrigen Modulatorelektroden isolierte Elektrode, welche die geometrische Größe des Modulators bestimmt. Jeder Fotodetektor (2) ist elektrisch an die Elektrode (12) eines benachbarten Modulators angeschlossen. Auf diese Weise werden viele Register gewonnen, die in ihrem Aufbau sehr einfach sind. Die Ansteuerung der Schieberegister erfolgt entweder elektrisch über Spannungsquellen (4 und 5) oder optisch.

FIG 2

EP 0 083 900 A2

'atentanwalt und Rechtsanwalt
Ing. Dipl.-Ing. Joachim B o e c k e r

0083900

6 Frankfurt / Main 1 , 27.12.1982
Rathenauplatz 2 - 8
Telefon: (0611) *282355 B/th 21 226 PE
Telex: 4 189 066 itax d

A S E A   Aktiebolag, Västeras/Schweden

Anordnung zur Umwandlung von Informationen aus der elektrischen Form in die optische Form und/oder umgekehrt

Die Erfindung betrifft eine Anordnung zur Umwandlung von Informationen aus der elektrischen Form in die optische Form und/oder umgekehrt gemäß dem Oberbegriff des Anspruches 1. Mit der Anordnung können Informationen in ein elektrooptisches Medium eingegeben, in diesem verschoben und aus diesem entnommen werden.

In der europäischen Patentanmeldung 82 10 2442.9 wird eine Anordnung zur Adressierung von flachen Displays, vor allem solcher, die aus Flüssigkeitskristallen aufgebaut sind, beschrieben. Bei dieser Anordnung erfolgt die Eingabe, die Ausgabe und Verschiebung der Information in einer, zwei oder drei Dimensionen durch Anwendung elektrooptisch rückgekoppelter Kreise, die untereinander otpoelektrisch zu elektrooptischen Schieberegistern zusammengekoppelt sind. Die Information wird in Speicherelementen gespeichert, die durch die genannte elektrooptische Rückkopplung ein sicheres bistabiles Verhalten haben.

In jüngster Zeit wurden experimentell Hysterese-Effekte in Flüssigkeitskristallen nachgewiesen (siehe z.B. N.A. Clark

/2

- 2 -

et.al., "Microsecond, bistabile, elektrooptic switching in liquid crystals", AIP news release, march 25, 1980).

Der Erfindung liegt die Aufgabe zugrunde, eine Anordnung der eingangs genannten Art in der Weise weiterzuentwickeln, daß der Aufbau der Anordnung wesentlich vereinfacht wird.

Zur Lösung dieser Aufgabe wird eine Anordnung nach dem Oberbegriff des Anspruches 1 vorgeschlagen, die erfindungsgemäß die im kennzeichnenden Teil des Anspruches 1 genannten Merkmale hat.

Vorteilhafte Weiterbildungen der Erfindung sind in den Unteransprüchen genannt.

Die Erfindung macht von den obengenannten Hysterese-Erscheinungen bei Flüssigkeitskristallen Gebrauch, und verwendet diese unmittelbar zur Herstellung bistaliber Speicherelemente in den Schieberegisterstrukturen der vorgenannten Speicherelemente. Dadurch werden die in den Schieberegistern verwendeten Kreise erheblich vereinfacht, und neue Kreiskonstruktionen können impliziert werden.

Gemäß der Erfindung werden also elektrisch und/oder optisch gesteuerte Schieberegister mit bistabilen elektrooptischen Modulatoren geschaffen, welche die in den Schieberegistern enthaltenen Speicherelemente darstellen. Im Verhältnis zu der eingangs genannten Patentanmeldung erhält man hierdurch bedeutend einfachere Kreise mit schnelleren Funktionen.

Dadurch, daß die elektrooptische Rückkopplung überflüssig wird, wird nämlich die Displaystruktur einfacher, und gleichzeitig kann die Adressierung schneller erfolgen.

Anhand der Figuren soll die Erfindung näher beschrieben werden. Es zeigen

Fig. 1 den typischen Verlauf der Hysteresekurve für einen bekannten Flüssigkristall-Modulator, wobei auf der x-Achse die Modulatorspannung U und auf der y-Achse die Lichttransmission T aufgetragen ist,

Fig. 2 ein Ausführungsbeispiel eines elektrisch gesteuerten Schieberegisters mit bistabilen Speicherelementen gemäß der Erfindung,

Fig. 3 das in einem Schieberegister gemäß Fig. 2 verwendbare Elektrodenmuster,

Fig. 4 die in einem Schieberegister nach Fig. 2 verwendbare Anordnung der Fotowiderstände und sonstigen Widerstände,

Fig. 5 einen Schnitt durch eine Struktur, wie sie für ein Schieberegister gemäß Fig. 2 verwendet werden kann,

Fig. 6 ein Ausführungsbeispiel eines optisch gesteuerten Schieberegisters gemäß der Erfindung.

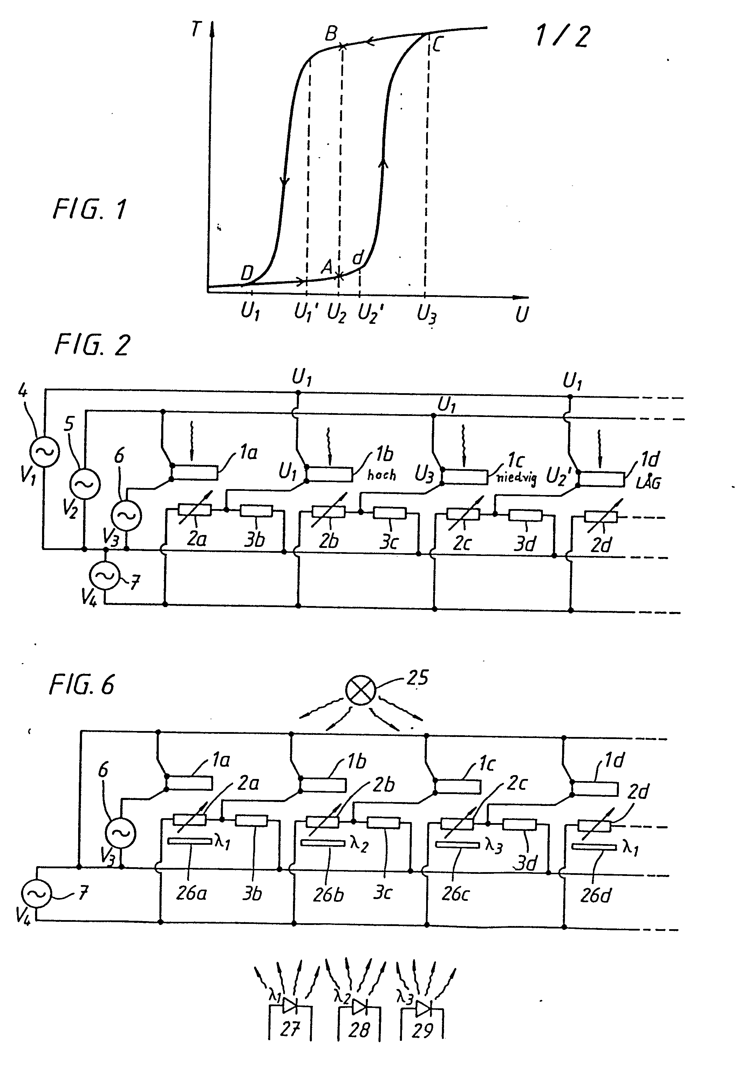

Gemäß der in Figur 1 gezeigten Hysteresekurve, die der Erläuterung der Funktion des Schieberegisters in Figur 2 dient, ergibt eine Modulatorspannung $U = U_1$ eine kleine Transmission. Auch wenn U auf $U_2$ erhöht wird, bleibt die Transmission klein. Wird jedoch $U = U_3$, so erhält man eine große Transmission T. Dieser große Transmissionswert bleibt im wesentlichen erhalten, wenn die Modulatorspannung U von $U_3$ auf $U_2$ zurückgenommen wird.

Die Grundfunktion bei der Informationseingabe und Informationsverschiebung geht aus Figur 2 hervor, in der 1a, b, c usw. die elektrooptischen Modulatorelemente mit einer innewohnenden Hysterese entsprechend Figur 1 bezeichnen. 2a, b, c usw. sind die Fotowiderstände (Fotoleiter), die den Transmissionszustand von einem Speicherelement zum folgenden übertragen. Die Spannungsquellen 4 und 5 steuern die Informationsverschiebung, die Spannungsquelle 6 steuert die Informationseingabe, und die Spannungsquelle 7

/4

- 4 -

speist die Fotowiderstände 2. Im weiteren werden die folgenden Bezeichnungen verwendet:

$R_{PC}$ = Widerstandswert der Fotowiderstände 2

$R_{PC}{}^a$ = der Wert $R_{PC}$ für den Fotowiderstand 2a

$R_{PCO}$ = der Dunkelwiderstandswert der Fotowiderstände 2

$R_O$ = der Widerstandswert der elektrischen Widerstände 3

$V_M$ = die Modulatorspannung am Modulatorelement 1

Somit gilt beispielsweise:

$$V_M{}^b = \frac{R_O{}^b}{R_O{}^b + R_{PC}{}^a} \cdot V_4 - V_1$$

Die Eingabe und Verschiebung eines Zustandes mit hoher Modulatortransmission kann in der nachstehenden Folge ablaufen:

1. $V_1$ und $V_2$ werden erhöht, so daß alle $V_M \leq U_1$ sind (Nullstellung)
2. $V_3$ wird erhöht, so daß $V_M{}^a = U_2$ ist,
3. $V_2$ wird gesenkt, so daß $V_M{}^a = U_3$, $V_M{}^b = U_2$, $V_M{}^c = U_2$ ist usw.
4. $V_2$ wird erhöht, so daß $V_M{}^a = U_2$ (B), $V_M{}^c = U_1$, $V_M{}^b = U_2$ ist,
5. $V_1$ wird gesenkt, so daß $V_M{}^b = U_3$, $V_M{}^c = U_2$, $V_M{}^d = U_2$ (A) ist,
6. $V_3$ wird gesenkt, so daß $V_M{}^a = U_1$ (D), $V_M{}^b = U_2$ (B), $V_M{}^2 = U_2$ (A) ist,
7. $V_1$ und $V_4$ werden erhöht, so daß $V_M{}^b = U_1{}'$, $V_M{}^d = U_1{}'$ und $V_M{}^c = U_3 = V_M{}^d = U_2$ ist.
8. $V_4$ wird gesenkt, so daß $V_M{}^b = U_1$, $V_M{}^c = U_2$ und $V_M{}^d = U_2$ ist usw.

Alternativ kann die Zeitkonstante des Schaltvorgangs des Modulators benutzt werden, wobei $V_4$ konstant gehalten wird (2-phasige Steuerung):

- 5 -

1. $V_1$ und $V_2$ werden erhöht, so daß alle $V_M \leq U_1$ sind (Nullstellung),

2. $V_3$ wird erhöht, so daß $V_M^a = U_2$ ist,

3. $V_2$ wird gesenkt, so daß $V_M^a = U_3$, $V_M^{c, e, g}$ usw. $= U_2$, $V_M^2 = U_2$, $V_M^{übrige} = U_1$ ist,

4. $V_2$ wird erhöht, so daß $V_M^a = U_2$, $V_M^{c, e, g}$ usw. $= U_1$, $V_M^b = U_2$, $V_M^{übrige} = U_1$ ist,

5. $V_1$ wird gesenkt, so daß $V_M^b = U_3$, $V_M^{d, f, h}$ usw. $= U_2$, $V_M^c = U_2$, $V_M^{übrige} = U_1$ ist,

6. $V_3$ wird gesenkt, so daß $V_M^a = U_1$, $V_M^b = U_2$ ist (Zustand B),

7. $V_2$ wird gesenkt, so daß $V_M^c = U_3$ ist, und gleichzeitig wird $V_1$ erhöht, so daß $V_M^{b,d,f}$ usw. $= U_1$ ist.

Hier wird also die Zeitverzögerung der Modulatoren ausgenutzt, d.h. ein Modulator geht schneller von dem Zustand A in den Zustand D über als von dem Zustand B in den Zustand D.

$V_M^{a, e, g}$ usw. $= U_2$, $V_M^d = U_2$,

8. $V_2$ wird erhöht, so daß $V_M^c = U_2$, $V_M^{a, e, g}$ usw. $= U_2$ ist.

Somit kann die Information durch die Spannungsquelle 6 eingegeben und durch abwechselnde Senkung und Erhöhung von $V_1$ und $V_2$ im Sinne der Figur 2 nach rechts verschoben werden.

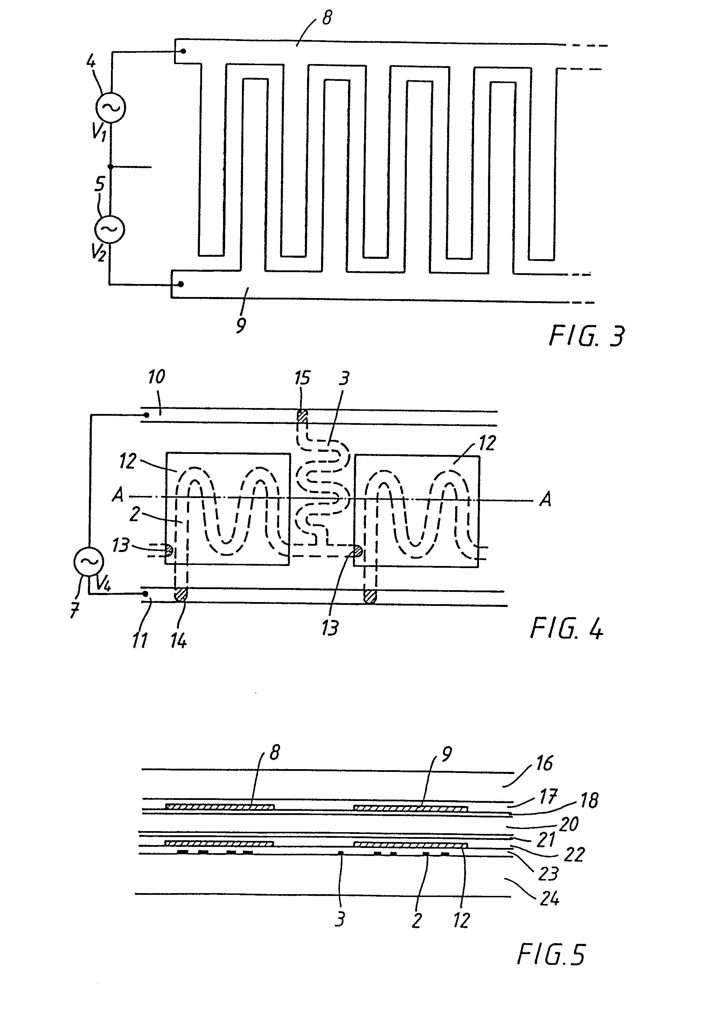

Figur 3 zeigt das Muster für den Elektrodenaufbau für den Anschluß der Spannungsquellen 4 und 5 an die Modulatoren 1a, b, c usw. Jeder zweite Modulator ist an die Spannungsquelle 4 angeschlossen und die übrigen Modulatoren sind an die Spannungsquelle 5 angeschlossen. Dies wird in Fig. 3 durch fingerförmige Elektroden 8 bzw. 9 verwirklicht.

Wenn die Elektroden nach Figur 3 auf der Oberseite der Modulatorschicht angebracht sind, so werden die elektrischen Kreise auf deren Unterseite entsprechend Figur 4 angebracht. Die Spannungsquelle 7 (siehe Figur 2) ist zwischen den elektrischen Leitern 10 und 11 angeschlossen. Im Punkt 15 ist der Widerstand 3 an den Leiter 10 angeschlossen, und im Punkt 14 ist der Fotowiderstand 2 an den Leiter 11 angeschlossen. Der Mittelpunkt zwischen dem Widerstand 3 und dem Fotowiderstand 2 ist an der Elektrode 12 im Punkt 13 angeschlossen. Zwischen den Elektroden 8, 9 in Figur 3 und den Elektroden 12 in Figur 4 tritt die Spannung $V_M$ auf. Gleichzeitig bestimmen die Elektroden 12 die seitliche Ausdehnung der Speicherelemente.

Figur 5 zeigt einen Schnitt durch die Struktur nach den Figuren 3 und 4 mit folgenden Schichten:

16 = transparente Scheibe, z.B. Glas oder Quarz,
17 = Isolatorschicht, z.B. $SiO_2$,
18 = lichtpolarisierende Schicht,
8 und 9 = transparente Elektroden,
20 = flüssiger Kristall mit Hysterese,
21 = lichtpolarisierende Schicht,
22 = Isolatorschicht, z.B. $SiO_2$,
12 = transparente Elektrode,
23 = Isolatorschicht, z.B. $SiO_2$,
2 = Fotowiderstand, z.B. CdS,
3 = Dünnfilmwiderstand,
24 = Substrat, z.B. Glas oder Quarz.

Figur 6 zeigt schließlich, wie ein Schieberegister nach Figur 2 für eine optische Steuerung modifiziert werden kann. Die Fotowiderstände 2a, b, c usw. sind mit optischen Filtern 26a, b, c usw. versehen, die auf Emissionslicht mit Wellenlängen um $\lambda_1$, $\lambda_2$ und $\lambda_3$ abgestimmt sind, das von den Lichtquellen 27, 28 bzw. 29 erzeugt wird. Um ein Schaltsignal zwischen naheliegenden Speicherelementen zu

- 7 -

erhalten, wird eine Lichtquelle 25 verwendet. (Diese Lichtquelle ist auch bei der Anordnung nach Fig. 2 vorhanden, dort jedoch nicht dargestellt.) Anstelle der in Figur 2 durch die Spannungsquellen 4 und 5 erzeugten Folge von hohen und niedrigen Spannungswerten zur Steuerung der Information wird in Figur 6 eine Folge von hohen und niedrigen Lichtintensitäten mit den Wellenlängen $\lambda_1$, $\lambda_2$ und $\lambda_3$ erzeugt. Durch die Formel

$$V_M = \frac{R_O}{R_O + R_{PC}} \cdot V_4$$

erhält man dieselben Möglichkeiten, $V_M$ mit den Lichtquellen 27 - 29 zu ändern, wie mit den Spannungsquellen 4 und 5 in Figur 2.

Die beschriebenen Anordnungen können im Rahmen des offenbarten allgemeinen Erfindungsgedankens in vielfacher Weise variiert werden. Insbesondere sei auf die Möglichkeit verwiesen, auf direktem optischen Wege Informationen über Fotowiderstände in die Speicherelemente einzuspeichern (vergl. Figur 6), was bei zweidimensionalen optischen Sensoren und Optoprozessoren von Interesse sein kann. Ferner kann jedes Speicherelement mit spektral codierten Fotowiderständen (mit mehreren optischen Filtern) versehen werden, was eine spektrale Adressierung ermöglicht.

Die Erfindung kann im Rahmen des offenbarten allgemeinen Erfindungsgedankens in vielfacher Weise variiert werden.

Patentanwalt und Rechtsanwalt
Dr.-Ing. Dipl.-Ing. Joachim B o e c k e r

0083900

6 Frankfurt/Main 1, 27.12.1982
Rathenauplatz 2-8
Telefon: (06 11) *28 23 55    B/th 21 226 PE
Telex: 4 189 066 itax d

- 8 -

## Patentansprüche

1. Anordnung zur Umwandlung von Informationen aus der elektrischen Form in die optische Form und/oder umgekehrt, wobei die Information als eine in einer, zwei oder drei Dimensionen und/oder zeitlich variierende Lichtintensität und/oder Lichtpolarisation und/oder Spektralzusammensetzung vorliegt und wobei die Umwandlung der Information durch elektrooptische Modulatoren, die z.B. aus Flüssigkeitskristallen bestehen, und Fotodetektoren, wie z.B. Fotowiderständen erfolgt, dadurch gekennzeichnet, daß die elektrooptischen Modulatoren (1) aus einem Material mit innewohnender Hysterese hinsichtlich der Abhängigkeit der Lichttransmission (T) von der Modulatorspannung (U) bestehen, daß sich die Modulatoren (1) im Strahlengang zwischen mindestens einer Lichtquelle (25) und den Fotodetektoren (2) befinden, von denen mindestens einer von der Lichtquelle aus gesehen, hinter jedem Modulator (1) angeordnet ist, daß jeder Modulator auf seiner einen Seite eine von den übrigen Modulatorelektroden isolierte Elektrode (12) hat, welche die geometrische Größe des Modulators bestimmt, und daß jeder Fotodetektor (2) elektrisch an die Elektrode (12) mindestens eines Modulators (z.B. 1c) angeschlossen ist, der in der Nähe des Modulators (1b) plaziert ist, hinter dem der betreffende Fotodetektor (2) optisch angeordnet ist.

2. Anordnung nach Anspruch 1, dadurch gekennzeichnet, daß die optischen Modulatoren (1a, b, c usw.) infolge ihrer Hysterese in einem vorgegebenen Modulatorspannungsintervall zwei verschiedene Zustände mit niedriger beziehungsweise hoher Lichttransmission annehmen können und daß die von den Fotodetektoren (2) optoelektrisch verbundenen Modulatoren elektrisch und/oder optisch sequential zwischen den genannten Zuständen gesteuert werden können.


3. Anordnung nach Anspruch 2, dadurch gekennzeichnet, daß die elektrooptischen Modulatoren (1a, b, c usw.) die Speicherelemente eines Schieberegisters bilden, in welchem die Information durch elektrische und/oder optische Steuerung geändert wird.

4. Anordnung nach einem der vorhergehenden Ansprüche, dadurch gekennzeichnet, daß die optischen Modulatoren bzw. Speicherelemente aus flüssigem Kristallmaterial bestehen, das auf jeder Seite mit einem Elektrodenmuster (8, 9, 12) zur Erzeugung der Modulatorspannung (U) versehen ist, daß die geometrischen Abmessungen der Speicherelemente im wesentlichen von dem Elektrodenmuster (12) auf der Seite des Flüssigkristalls bestimmt wird, auf der die Fotodetektoren plaziert sind, daß das letztgenannte Elektrodenmuster aus voneinander isolierten Inseln (12) besteht und daß diese Inseln elektrisch an Spannungsteiler angeschlossen sind, die aus den Fotowiderständen (3) bestehen, die gegenüber dem vom Fotowiderstand abgetasteten Licht weniger empfindlich sind als die Fotoleiter.

5. Anordnung nach Anspruch 4, dadurch gekennzeichnet, daß die Widerstände (3) Dünn- oder Dickfilmwiderstände sind und/oder daß sie aus der Impedanz zwischen den Modulatorelektroden (8, 9, 12) bestehen.

6. Anordnung nach Anspruch 4 oder 5, dadurch gekennzeichnet, daß der Transmissionszustand der Speicherelemente (optischen Modulatoren) zwischen den optoelektrisch verbundenen Speicherelementen dadurch übertragen wird, daß die Elektroden (12) und die Spannungsteiler (2, 3) elektrisch an Spannungsquellen (4, 5, 7) angeschlossen

- 10 -

sind, deren Ausgangsspannungen in einer bestimmten
Folge variiert werden.

7. Anordnung nach Anspruch 6, dadurch gekennzeichnet, daß
jedes zweite, jedes dritte oder jedes vierte usw. Speicherelement an eine gemeinsame Spannungsquelle angeschlossen ist, wobei die 2, 3, 4 usw. Spannungsquellen
durch selektiv gesteuerte Ausgangsspannung zur Steuerung
der Informationsübertragung verwendet werden.

8. Anordnung nach Anspruch 7, dadurch gekennzeichnet, daß
jedes zweite Speicherelement an eine Spannungsquelle (4)
angeschlossen ist und daß die übrigen Speicherelemente
an eine andere Spannungsquelle (5) über zwei zusammengesetzte Fingerelektrodenmuster (8, 9) auf der Seite
des Flüssigkristalls angeschlossen ist, auf die das
Licht von der Lichtquelle (25) fällt.

9. Anordnung nach Anspruch 4 oder 5, dadurch gekennzeichnet, daß der Fotowiderstand (2) und/oder einer oder
mehrere mit dem Fotoleiter (2) in Reihe und/oder parallel geschaltete Fotowiderstände mit optischen Filtern
(26) versehen ist/sind, wobei das optische Filter (26)
jedes zweiten, jedes dritten usw. Speicherelementes in
mindestens einem Wellenlängenbereich dieselben spektralen Transmissionseigenschaften hat.

10. Anordnung nach Anspruch 9, dadurch gekennzeichnet, daß
das genannte Schieberegister optisch dadurch gesteuert
wird, daß die Lichtstärke von zwei, drei usw. Lichtquellen (27, 28, 29) mit verschiedenen Emissionsspektren in einer bestimmten Folge erhöht und gesenkt wird
und daß die genannten Emissionsspektren den Transmissionsspektren der Filter (26) derart angepaßt sind,
daß man eine selektive Beleuchtung der betreffenden
Fotoleiter (2) erhält.

- 11 -

11. Anordnung nach einem der Ansprüche 3 - 10, dadurch gekennzeichnet, daß das Schieberegister mit einem zweiphasigen Steuerschema steuerbar ist, wobei die Zeitkonstante für die Modulatorschaltung zur Verhinderung einer unkontrollierten Informationsübertragung verwendet wird.

12. Anordnung nach einem der Ansprüche 3 - 10, dadurch gekennzeichnet, daß das Schieberegister mit einem dreiphasigen Steuerschema steuerbar ist, wobei die Übertragung des Modulatorzustandes zwischen zwei verbundenen Speicherelementen isoliert vorgenommen werden kann, ohne daß die Gefahr einer Informationsübertragung auf in der Nähe liegende Speicherelemente besteht.

FIG. 1

FIG. 2

FIG. 6

FIG. 3

FIG. 4

FIG.5